# FASCICULE DE BREVET EUROPEEN

(11) **EP 3 273 486 B1**
(45) Date de publication et mention de la délivrance du brevet: **18.05.2022**
(21) Numéro de dépôt: 17156145.9
(22) Date de dépôt: 14.02.2017
(51) Int. Cl.: H01L 29/861, H01L 21/324, H01L 27/02, H01L 27/08

(54) **DISPOSITIF DE PROTECTION CONTRE DES SURTENSIONS**
SCHUTZVORRICHTUNG GEGEN ÜBERSPANNUNGEN
DEVICE FOR SURGE PROTECTION

(30) Priorité: 20.07.2016 FR 1656923
(43) Date de publication de la demande: 24.01.2018
(73) Titulaire: STMicroelectronics (Tours) SAS, 37100 Tours (FR)
(72) Inventeur: ARNAUD, Aurélie, 37540 SAINT-CYR-SUR-LOIRE (FR)
(74) Mandataire: Cabinet Beaumont

(56) Documents cités:
- US-A1- 2014 036 399
- US-A1- 2015 001 672
- US-A1- 2015 002 967
- US-A1- 2015 137 305
- US-A1- 2015 221 628

## Description

### Domaine

La présente demande concerne un procédé de fabrication d'un dispositif de protection contre les surcharges électrostatiques.

### Exposé de l'art antérieur

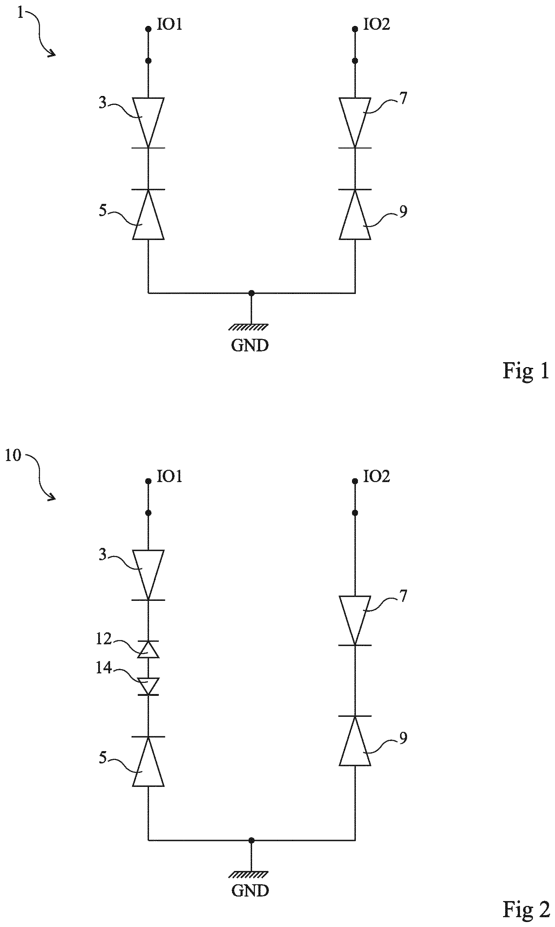

La figure 1 est un schéma électrique illustrant un circuit 1 de protection contre les surtensions présenté dans le brevet américain de référence US2015/02221628 A1. Le circuit 1 est connecté entre deux bornes d'entrée/sortie, IO1 et IO2, d'un circuit à protéger et une borne de référence GND. Le circuit 1 comprend, en série, entre la borne d'entrée/sortie IO1 et la borne de référence GND, une diode 3 en direct et une diode 5 avec une tension d'avalanche contrôlée en inverse. Le circuit de protection comprend en outre, entre la borne d'entrée/sortie IO2 et la borne de référence GND, une diode 7 en direct et une diode 9 avec une tension d'avalanche contrôlée en inverse. Le signal sur les bornes IO1 et IO2 peut par exemple être un signal de données binaire. En cas de surtension sur la borne IO1, celle-ci est évacuée par la diode 3 et la diode 5. La surtension est alors limitée à une tension supérieure aux tensions positives normales du signal de données. En cas de surtension sur la borne IO2, celle-ci est évacuée par la diode 7 et la diode 9. La surtension est alors limitée à une tension supérieure aux tensions positives normales du signal de données.

Le document US 2015/0002967 A1 divulgue un dispositif semi-conducteur comprenant une première borne et une seconde borne.

Une première diode est connectée entre la première et la seconde borne avec une anode connectée à la première borne. Une deuxième diode et une troisième diode sont connectées en série l'une à l'autre et en parallèle avec la première diode entre la première et la seconde borne. La deuxième diode a une anode connectée à la deuxième borne, et la troisième diode a une anode connectée à la première borne. La troisième diode est une diode Zener ayant une capacité supérieure à chacune d'une capacité de la première diode et d'une capacité de la deuxième diode. Une quatrième diode est incluse dans une série entre la deuxième et la troisième diode.

La deuxième diode, la quatrième diode et la troisième diode sont formées, dans cet ordre, dans un substrat semi-conducteur, par un empilement des couches dopées p/n⁺/n⁻/p/n⁻/p⁺ et disposées de la première borne à la deuxième borne respectivement.

Des dispositifs de protection contre des surtensions telles que des surcharges électrostatiques sont également connus des documents US 9059324 B2, US 9177950 B2 et US 8953290 B2.

Il est souhaitable que le circuit de protection n'influence ni le fonctionnement et les performances du circuit à protéger, ni la forme des signaux fournis. Notamment, si le signal sur la borne à protéger est un signal binaire, en créneaux, pour conserver la forme carrée de ce signal, la capacité totale du circuit de protection doit être la plus faible possible.

### Résumé

Un mode de réalisation prévoit un procédé de fabrication d'un dispositif de protection contre les surcharges électrostatiques selon la revendication 1 et comprenant les étapes suivantes : implanter dans un substrat semiconducteur très fortement dopé d'un premier type de conductivité une première couche enterrée fortement dopée d'un deuxième type de conductivité ; implanter dans le substrat une deuxième couche enterrée fortement dopée du premier type de conductivité ; former par épitaxie une première couche faiblement dopée du deuxième type de conductivité ; et réaliser une deuxième couche fortement dopée du premier type de conductivité, le procédé comprenant la réalisation d'une série de recuits entraînant la diffusion des atomes dopants du substrat à travers la première couche enterrée, pour former une troisième couche du premier type de conductivité entre la première couche enterrée et la première couche.

Selon un mode de réalisation, le coefficient de diffusion des atomes dopants du substrat est plus grand que le coefficient de diffusion des atomes dopants de la première couche enterrée.

Selon un mode de réalisation, le substrat est dopé au bore et la première couche enterrée est dopée à l'arsenic.

### Brève description des dessins

Ces caractéristiques et avantages, ainsi que d'autres, seront exposés en détail dans la description suivante de modes de réalisation non compris dans l'invention revendiquée et de modes de réalisation particuliers faite à titre non limitatif en relation avec les figures jointes parmi lesquelles :
la figure 1, décrite précédemment, illustre un circuit de protection contre les surcharges électrostatiques ;
la figure 2 illustre un mode de réalisation d'un circuit de protection contre les surcharges électrostatiques non compris dans l'invention revendiquée et destiné à faciliter la compréhension de l'invention ;
la figure 3 illustre un mode de réalisation d'un dispositif de protection contre les surcharges électrostatiques non compris dans l'invention revendiquée et destiné à faciliter la compréhension de l'invention, ledit dispositif étant fabriqué par le procédé revendiqué ; et
les figures 4 et 5 sont des graphiques représentant les niveaux de dopage du dispositif de protection contre les surcharges électrostatiques de la figure 3.

### Description détaillée

De mêmes éléments ont été désignés par de mêmes références dans les différentes figures et, de plus, les diverses figures ne sont pas tracées à l'échelle. Par souci de clarté, seuls les éléments qui sont utiles à la compréhension des modes de réalisation non compris dans l'invention revendiquée et destinés à faciliter la compréhension de l'invention ainsi que des modes de réalisation décrits ont été représentés et sont détaillés.

Dans la description qui suit, lorsque l'on fait référence à des qualificatifs de position absolue, tel que le terme "arrière", ou relative, tels que les termes "supérieur" et "inférieur", il est fait référence à l'orientation des figures. Sauf précision contraire, l'expression "de l'ordre de" signifie à 10 % près, de préférence à 5 % près.

La figure 2 est un schéma électrique d'un mode de réalisation non compris dans l'invention revendiquée d'un circuit 10 de protection contre les surcharges électrostatiques. Le circuit 10 comprend de mêmes éléments désignés par de mêmes références que le circuit 1 présenté en figure 1. Le circuit 10 comprend en outre en série, entre la diode 3 et la diode 5, une diode 12 en inverse et une diode 14 en direct. La diode 12 est du type fonctionnant en perçage, c'est-à-dire qu'elle est conductrice en inverse avec une très faible chute de tension. L'ensemble des diodes 12 et 14 n'affecte donc pas le fonctionnement du circuit de protection dans l'avalanche mais introduit deux capacités série supplémentaires du fait de l'introduction de deux jonctions supplémentaires : les jonctions correspondant aux diodes 12 et 14.

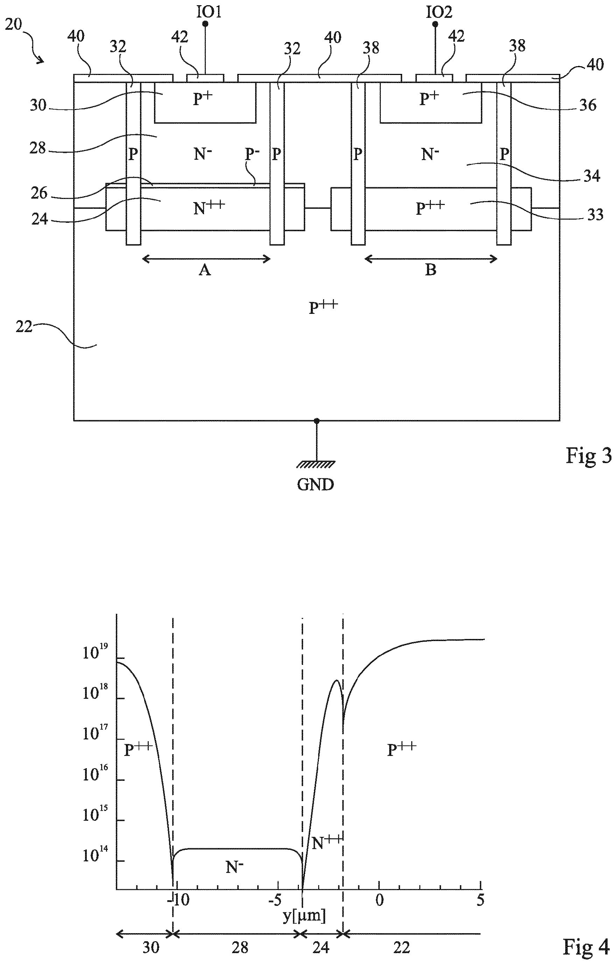

La figure 3 illustre un mode de réalisation non compris dans l'invention revendiquée d'un dispositif 20 de protection contre les surcharges électrostatiques dont le schéma électrique correspond à celui représenté en figure 2. Le dispositif 20 comprend un substrat semiconducteur 22 très fortement dopé de type P et dont la face arrière est connectée au noeud de référence GND. Le dispositif 20 comprend en outre successivement sur une portion A du substrat 22 :
- une couche semiconductrice enterrée 24 fortement dopée de type N ;
- une couche semiconductrice fine 26 faiblement dopée de type P, dont l'épaisseur est comprise entre 0,3 et 3 µm ;
- une couche semiconductrice 28 faiblement dopée de type N, réalisée par épitaxie et dont l'épaisseur peut être supérieure à 5 µm, par exemple comprise entre 10 µm et 50 µm ; et
- un caisson semiconducteur 30 fortement dopé de type P, formé dans la couche épitaxiale 28 et dont l'épaisseur est comprise entre 1 et 5 µm.

Des puits d'isolation 32 s'étendent de la face supérieure de la couche épitaxiale 28 jusqu'au substrat 22 afin de délimiter latéralement la portion A du substrat 22.

Le dispositif comprend en outre successivement sur une portion B du substrat 22 :
- une couche semiconductrice enterrée 33 fortement dopée de type P ;
- une couche semiconductrice 34 faiblement dopée de type N, réalisée par épitaxie en même temps que la couche 28 ; et
- un caisson semiconducteur 36 fortement dopé de type P, formé dans la couche épitaxiale 34 et dont l'épaisseur est comprise entre 1 et 5 µm.

Des puits d'isolation 38 s'étendent de la face supérieure de la couche 34 et jusqu'au substrat 22 afin de délimiter latéralement la portion B du substrat 22.

Les puits d'isolation 32 et 38 étant formés par diffusion, on comprendra que leurs contours ne sont pas aussi nets que ceux représentés sur la figure 3.

A titre de variante, les puits d'isolation 32 et 38 pourraient être remplacés par des tranchées isolantes.

Sur la face supérieure du dispositif 20 repose une couche isolante 40, ne recouvrant pas toute la surface des faces supérieures des caissons 30 et 36. Sur chaque caisson 30, 36 repose une métallisation de contact 42 connectée à une borne du circuit à protéger. Le caisson 30 est ainsi connecté à la borne IO1 et le caisson 36 est ainsi connecté à la borne IO2.

La correspondance entre le schéma électrique de la figure 2 et le schéma structurel de la figure 3 est la suivante. La jonction entre le caisson 30 et la couche épitaxiale 28 forme la diode 3 en direct. La jonction entre la couche épitaxiale 28 et la couche fine P⁻ 26 forme la diode 12 en inverse fonctionnant en perçage. La jonction entre la couche fine P⁻ 26 et la couche enterrée 24 forme la diode 14 en direct. La jonction entre la couche enterrée 24 et le substrat 22 forme la diode 5. La jonction entre le caisson 36 et la couche épitaxiale 34 forme la diode 7 en direct. La jonction entre la couche épitaxiale 34 et la couche enterrée 33 forme la diode 9 en inverse.

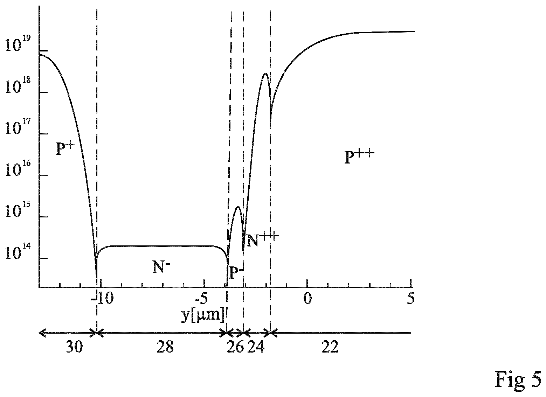

La figure 4 est un graphique représentant un exemple des niveaux de dopage de couches successives réalisées sur la portion A du substrat 22 en fonction de la profondeur. Ces niveaux de dopage résultent d'étapes d'implantation et d'épitaxie après éventuellement des recuits de redistribution mais avant la réalisation de l'ensemble des recuits conduisant à une structure finale qui sera décrite ci-après en relation avec la figure 5.

Dans cet exemple, le substrat 22 a un niveau de dopage compris entre 5×10¹⁸ et 10²⁰ atomes/cm³, par exemple égal à 3×10¹⁹ atomes/cm³. La couche enterrée 24 a un niveau de dopage compris entre 10¹⁸ et 10¹⁹ atomes/cm³, par exemple égal à 2×10¹⁸ atomes/cm³. La couche épitaxiale 28 a un niveau de dopage compris entre 10¹³ et 10¹⁵ atomes/cm³, par exemple égal à 4×10¹⁴ atomes/cm³. Le caisson 30 a un niveau de dopage compris entre 5×10¹⁸ et 5×10¹⁹ atomes/ cm³, par exemple égal à 9×10¹⁸ atomes/cm³.

Le procédé de fabrication du dispositif 20 comporte les étapes successives suivantes, réalisées à partir d'un substrat 22 très fortement dopé de type P, par des atomes de bore :
- réaliser la couche enterrée 24 fortement dopée de type N, par implantation d'atomes d'arsenic ;
- réaliser la couche enterrée 33 fortement dopée de type P, par implantation ;
- réaliser les couches 28 et 34 faiblement dopées de type P, par épitaxie ; et
- réaliser, de préférence par implantation, les caissons 30 et 36 fortement dopés de type P.

La figure 5 est un graphique représentant les niveaux de dopage des couches semiconductrices empilées sur la portion A du substrat 22 en fonction de la profondeur. Ces niveaux de dopage résultent des étapes d'implantation et d'épitaxie mais aussi de tout l'ensemble des recuits conduisant à la structure décrite en figure 3. En comparant la figure 5 à la figure 4, on remarque l'apparition d'une couche fine 26 faiblement dopée de type P entre la couche épitaxiale 28 dopée de type N et la couche enterrée 24 dopée de type N. Le niveau de dopage de la couche fine P⁻ 26 est de l'ordre de 10¹⁵ atomes/cm³ et son épaisseur est de l'ordre de 1 µm. La couche fine 26 apparaît grâce à la diffusion des atomes de bore dopant le substrat à travers la couche enterrée 24. Cette diffusion est possible car la couche enterrée 28 résulte de l'implantation d'atomes d'arsenic et non d'atomes de phosphore. Les atomes de bore du substrat 22 diffusent beaucoup plus vite que les atomes d'arsenic de la couche enterrée 24 et peuvent donc diffuser à travers cette couche enterrée 24 pour former la couche fine P⁻ 26. Les caractéristiques des différents recuits nécessaires au procédé de fabrication du dispositif 20, seront ajustées par l'homme de l'art pour favoriser cette diffusion.

Si on considère un dispositif dont la portion A a une surface comprise entre 6000 et 10000 µm², par exemple de 6700 µm², la capacité de la diode 3 en série avec la diode 5 est de l'ordre de 550 fF en l'absence de la couche fine P⁻ 26, et de 450 fF en présence de la couche fine P⁻ 26, ce qui correspond à une baisse de 20 % de cette capacité.

Un avantage du dispositif décrit ici, muni de la couche fine P⁻ supplémentaire 26, est qu'il peut être obtenu sans ajouter d'étape supplémentaire au procédé de fabrication d'un dispositif classique non muni de la couche fine P⁻ 26.

On appelle ici, comme cela est usuel :
- couche semiconductrice faiblement dopée, une couche dont la concentration en atomes dopants est comprise entre 10¹⁴ et 5×10¹⁵ atomes/cm³ ;
- couche semiconductrice fortement dopée, une couche dont la concentration en atomes dopants est comprise entre 10¹⁷ et 10¹⁸ atomes/cm³ ; et
- couche semiconductrice très fortement dopée, une couche dont la concentration en atomes dopants est comprise entre 10¹⁸ et 10²⁰ atomes/cm³.

Des modes de réalisation non compris dans l'invention revendiquée et destiné à faciliter la compréhension de l'invention et des modes de réalisation particuliers ont été décrits.

Diverses variantes et modifications apparaîtront à l'homme de l'art. En particulier :
- tous les types de conductivité peuvent être simultanément inversés ;
- selon un mode de réalisation non compris dans l'invention revendiquée mais destiné à faciliter la compréhension de l'invention, on pourrait envisager d'implanter directement des atomes de bore après la formation de la couche enterrée 24 pour former la couche fine 26 ; et
- tout type de circuit de protection peut être envisagé sur la portion B du substrat.

## Revendications

1. Procédé de fabrication d'un dispositif (20) de protection contre les surcharges électrostatiques, comprenant les étapes suivantes :
implanter dans une première portion (A) d'un substrat (22) semiconducteur très fortement dopé d'un premier type de conductivité, une première couche enterrée (24) fortement dopée d'un deuxième type de conductivité ;
implanter dans une deuxième portion (B) du substrat (22) une deuxième couche enterrée (33) fortement dopée du premier type de conductivité, ladite deuxième portion (B) étant différente de ladite première portion (A);
former par épitaxie une première couche (28) faiblement dopée du deuxième type de conductivité sur au moins la première couche enterrée (24) ; et
réaliser une deuxième couche (30) fortement dopée du premier type de conductivité sur au moins la première couche (28) faiblement dopée,
le procédé comprenant la réalisation d'une série de recuits entraînant la diffusion des atomes dopants du substrat (22) à travers la première couche enterrée (24), pour former une troisième couche (26) du premier type de conductivité entre la première couche enterrée (24) et la première couche (28).

2. Procédé selon la revendication 1, dans lequel le coefficient de diffusion des atomes dopants du substrat (22) est plus grand que le coefficient de diffusion des atomes dopants de la première couche enterrée (24).

3. Procédé selon la revendication 2, dans lequel le substrat (22) est dopé au bore et la première couche enterrée (24) est dopée à l'arsenic.

4. Procédé selon l'une quelconque des revendications 1 à 3, on empile sur la deuxième couche (33) de la deuxième portion (B) du substrat (22) :
une quatrième couche (34) semiconductrice faiblement dopée du deuxième type de conductivité, ladite première couche (28) et ladite quatrième couche (34) étant formées simultanément et
une cinquième couche (36) semiconductrice fortement dopée du premier type de conductivité sur au moins la quatrième couche.

5. Procédé selon la revendication 4, dans lequel une première métallisation de contact (42) repose sur la deuxième couche (30) et une deuxième métallisation de contact (42) repose sur la cinquième couche (36).

## Patentansprüche

1. Verfahren zur Herstellung einer Elektrostatik-Überspannung-Schutzvorrichtung (20), wobei das Verfahren die folgenden Schritte aufweist:
Implantieren in einem ersten Abschnitt (A) eines sehr stark dotierten Halbleitersubstrats (22) eines ersten Leitfähigkeitstyps einer ersten, stark dotierten vergrabenen Schicht (24) eines zweiten Leitfähigkeitstyps;
Implantieren in einem zweiten Abschnitt (B) des Substrats (22) einer zweiten, stark dotierten vergrabenen Schicht (33) des ersten Leitfähigkeitstyps, wobei sich der zweite Abschnitt (B) von dem ersten Abschnitt (A) unterscheidet;
Ausbilden einer ersten, leicht dotierten Schicht (28) des zweiten Leitfähigkeitstyps durch Epitaxie auf wenigstens der ersten vergrabenen Schicht (24); und
Ausbilden einer zweiten, stark dotierten Schicht (30) des zweiten Leitfähigkeitstyps auf wenigstens der ersten leicht dotierten Schicht (28),
wobei das Verfahren das Durchführen einer Reihe von Anneal- oder Ausheizvorgängen aufweist, welche die Diffusion der Dotieratome des Substrats (22) durch die erste vergrabene Schicht (24) bewirken, um eine dritte Schicht (26) des ersten Leitfähigkeitstyps zwischen der ersten vergrabenen Schicht (24) und der ersten Schicht (28) zu bilden.

2. Verfahren nach Anspruch 1, wobei der Diffusionskoeffizient der Dotieratome des Substrats (22) größer ist als der Diffusionskoeffizient der Dotieratome der ersten vergrabenen Schicht (24).

3. Verfahren nach Anspruch 2, wobei das Substrat (22) mit Bor dotiert ist und die erste vergrabene Schicht (24) mit Arsen dotiert ist.

4. Verfahren nach einem der Ansprüche 1 bis 3, wobei auf der zweiten Schicht (33) des zweiten Abschnitts (B) des Substrats (22) Folgendes aufgebracht wird:
eine vierte, leicht dotierte Halbleiterschicht (34) des zweiten Leitfähigkeitstyps, wobei die erste Schicht (28) und die vierte Schicht (34) gleichzeitig ausgebildet werden, und
eine fünfte, stark dotierte Halbleiterschicht (36) des ersten Leitfähigkeitstyps auf wenigstens der vierten Schicht.

5. Verfahren nach Anspruch 4, wobei eine erste Kontaktmetallisierung (42) auf der zweiten Schicht (30) und eine zweite Kontaktmetallisierung (42) auf der fünften Schicht (36) aufliegt.

## Claims

1. Method of manufacturing an electrostatic surge protection device (20), comprising the steps of:
implanting in a first portion (A) of a very heavily doped semiconductor substrate (22) of a first conductivity type, a first heavily doped buried layer (24) of a second conductivity type;
implanting in a second portion (B) of the substrate (22) a second heavily doped buried layer (33) of the first conductivity type, said second portion (B) being different from said first portion (A);
forming by epitaxy a first lightly doped layer (28) of the second conductivity type on at least the first buried layer (24); and
forming a second heavily doped layer (30) of the second conductivity type on at least the first lightly doped layer (28),
the method comprising performing a series of anneals causing the diffusion of the dopant atoms of the substrate (22) through the first buried layer (24), to form a third layer (26) of the first conductivity type between the first buried layer (24) and the first layer (28).

2. Method according to claim 1, wherein the diffusion coefficient of the dopant atoms of the substrate (22) is greater than the diffusion coefficient of the dopant atoms of the first buried layer (24).

3. Method according to claim 2, wherein the substrate (22) is boron-doped and the first buried layer (24) is arsenic-doped.

4. Method according to any of claims 1 to 3, wherein there is stacked on the second layer (33) of the second portion (B) of the substrate (22):
a fourth lightly doped semiconductor layer (34) of the second conductivity type, said first layer (28) and said fourth layer (34) being formed simultaneously, and
a fifth heavily doped semiconductor layer (36) of the first conductivity type on at least the fourth layer.

5. Method according to claim 4, wherein a first contact metallization (42) rests on the second layer (30) and a second contact metallization (42) rests on the fifth layer (36).
